# EUROPÄISCHE PATENTSCHRIFT

(11) **EP 2 388 555 B1**
(45) Veröffentlichungstag und Bekanntmachung des Hinweises auf die Patenterteilung: **13.01.2016**
(21) Anmeldenummer: 11004052.4
(22) Anmeldetag: 17.05.2011
(51) Int. Cl.: G01D 5/20, H03K 17/95

(54) **Induktiver Sensor und Verfahren zu dessen Montage**
Inductive sensor and method for its assembly
Capteur inductif et son procédé de montage

(30) Priorität: 21.05.2010 DE 102010021189
(43) Veröffentlichungstag der Anmeldung: 23.11.2011
(73) Patentinhaber: Baumer Electric AG, 8501 Frauenfeld (CH)
(72) Erfinder: Reetmeyer, Burkhard, 78469 Konstanz (DE)
(74) Vertreter: Strauss, Steffen

(56) Entgegenhaltungen:
- EP-A1- 2 085 993
- EP-A2- 1 811 272
- DE-A1- 10 013 218
- DE-A1- 10 048 290
- US-A- 4 090 091
- US-A- 5 034 621

## Beschreibung

### Erfindung

Die Erfindung betrifft einen induktiven Sensor, insbesondere einen Näherungssensor sowie ein Verfahren zu dessen Montage.

### Hintergrund der Erfindung

Induktive Sensoren sind bekannt. Es handelt sich dabei um Sensoren, welche eine Spule umfassen, die in der Regel um einen Ferrit-Kern gewickelt ist und welche der Ausbildung eines Oszillators dient.

Neben dem Oszillator umfasst ein derartiger Näherungssensor in der Regel eine Leiterplatte, welche mit integrierten Schaltkreisen bestückt ist, die beispielsweise eine Auswerteelektronik und einen Verstärker umfassen.

Bei Annährung eines metallischen Objektes an den Sensor wird der Oszillator verstimmt und es kann so ein die Annäherung widerspiegelndes Signal ausgegeben werden.

Sämtliche Bauteile des Sensors sind zumeist in ein Gehäuse integriert, wobei typischerweise die Spule an der Stirnfläche des Sensors angeordnet ist. Hinter der Spule sitzt typischerweise die Leiterplatte, mit den elektronischen Komponenten. Auf der Rückseite des Sensors, also der der Spule gegenüberliegenden Seite, sind Anschlusskontakte vorgesehen, die eine Schnittstelle bilden, um den Sensor anzusteuern und dessen Signale auszuwerten.

In der Regel sind derartige Näherungssensoren hermetisch gekapselt. Die Montage bekannter Sensoren ist aufwendig. So muss die Leiterplatte elektrisch mit den Kontakten der Spule sowie mit den Anschlusskontakten zum Anschließen des Sensors verbunden werden. Aufgrund der Integration in ein in der Regel kreiszylinderförmig ausgebildetes Sensorgehäuse ist es dabei zumeist nicht möglich, die oben genannten Kontakte alle auf eine Seite der Leiterplatte zu legen, um diese somit von einer Seite verlöten zu können.

Zur Vereinfachung der Montage schlägt die WO2007/131374 vor, statt einer Lötverbindung Kontaktschneiden zu verwenden.

Die Montage des Sensorgehäuses und die Befestigung der Spule bzw. des Spulengehäuses erfolgt üblicherweise mittels einer Klebeverbindung. Derartige Klebeverbindungen haben den Nachteil, dass aufgrund der erforderlichen Aushärtezeiten des Klebemittels während der Montage Wartezeiten entstehen. Des Weiteren weisen die einzuklebenden Bauelemente Toleranzen auf. Dies kann zu Qualitätsschwankungen der einzelnen Sensoren führen, da in machen Fällen die einzelnen Komponenten nicht wie gewünscht positioniert und so aufeinander abgestimmt sind.

### Aufgabe der Erfindung

Der Erfindung liegt die Aufgabe zugrunde, einen induktiven Sensor bereitzustellen, bei welchem der Montageaufwand reduziert ist. Eine weitere Aufgabe der Erfindung ist es montagebedingte Qualitätsschwankungen zu reduzieren.

### Zusammenfassung der Erfindung

Die Aufgabe wird gelöst durch einen induktiven Sensor, insbesondere einen Näherungssensor sowie mit einem Verfahren zu dessen Montage mit den Merkmalen des Anspruchs 1 bzw. Anspruchs 13.

Bevorzugte Ausführungsformen und Weiterbildungen der Erfindung sind den jeweiligen Unteransprüchen zu entnehmen.

So wird erfindungsgemäß ein Sensor vorgeschlagen, der eine in einem Gehäuse angeordnete Spule umfasst, welche mit einer ebenfalls in dem Gehäuse angeordneten Leiterplatte elektrisch verbunden ist, wobei an der Leiterplatte auf einer der Spule gegenüberliegenden Seite des Gehäuses Kontakte zum Anschluss des Sensors angebracht sind, und wobei die Spule zumindest zwei asymmetrisch zu einer Spulenachse verlaufende Kontakte aufweist, die mit der Leiterplatte verbunden sind.

Die Leiterplatte ist mit elektronischen Komponenten bestückt, beispielsweise mit integrierten Schaltkreisen, welche der Auswertung und/oder Verstärkung der Sensorsignale dienen. Ein derartiger Sensor ist in der Regel in Richtung einer Spulenachse wirksam. Die Windungen der Spule verlaufen in der Regel senkrecht zur Leiterplatte.

An der gegenüberliegenden Seite des Gehäuses sind Kontakte zum Anschluss des Sensors angebracht, welche elektrisch mit der Leiterplatte verbunden sind. Diese Kontakte können Teil eines Steckers sein, oder, wie es bei einer alternativen Ausführungsform vorgesehen ist, Teil eines Kabels, welches aus dem Sensorgehäuse heraus geführt ist und dem Anschluss des Sensors dient.

Es versteht sich, dass als Leiterplatte sowohl eine flexible als auch eine starre Leiterplatte verwendet werden kann. Gemäß der Erfindung weist die Spule zumindest zwei asymmetrisch zu einer Spulenachse verlaufende Kontakte auf, welche mit der Leiterplatte verbunden sind.

Die Spulenachse ist dadurch definiert, dass diese in der Mitte der Spule senkrecht durch eine Ebene verläuft, welche von den Windungen der Spule gebildet wird.

Weiter weist die Spule zwei Kontakte auf, welche bei herkömmlichen Spulen in der Regel gegenüber der Spulenachse symmetrisch angeordnet sind und sich mithin genau gegenüber liegen.

Gemäß der Erfindung liegen die Spulen kontakte dagegen nicht gegenüber, sondern sind asymmetrisch angeordnet. Vorzugsweise schließen die Mittelpunkte der Kontakte zur Spulenachse hin einen Winkel zwischen 60 und 170°, besonders bevorzugt zwischen 110 und 120° ein.

Auf diese Weise ist es möglich, beide Kontakte der Spule auf einer Seite einer genau in der Mitte des Gehäuses angeordneten Leiterplatte anzubringen.

In der Folge können beispielsweise sowohl die Spulenkontakte als auch die Anschlusskontakte des Sensors von einer Seite mit der Leiterplatte verlöten werden, was die Montage erheblich erleichtert.

Bei einer Weiterbildung der Erfindung ist die Spule auf einen Spulenkörper gewickelt, welcher die asymmetrisch zur Spulenachse verlaufenden Kontakte aufweist.

Die Verwendung eines Spulenkörpers ermöglicht im Gegensatz zu freitragenden Spulen die Ausbildung eines maßhaltigeren Bauelementes.

Bei einer Weiterbildung der Erfindung ist der Spulenkörper ringförmig mit einer mittigen Aussparung ausgebildet. Diese Aussparung weist bei einer Ausführungsform der Erfindung innere Klemmstege auf. Diese Klemmstege können beispielsweise der Befestigung auf einem Schalenkern dienen, welche ein Gehäuse der Spule bildet.

Dabei kann der Schalenkern Kanäle zur Durchführung der asymmetrisch verlaufenden Kontakte aufweisen. Der Schalenkern wird an einem Ende des Gehäuses angeordnet und kann exakt positioniert werden.

Bei einer bevorzugten Ausführungsform der Erfindung ist der Schalen kern form-und/oder kraftschlüssig befestigt. So kann auf die Verwendung von Klebstoffen bei der Montage mit den damit einhergehenden Wartezeiten verzichtet werden. Es ist insbesondere vorgesehen, dass die Leiterplatte selbst als Federelement wirksame Flügel aufweist, welche zumindest eine Klemmverbindung mit dem Schalenkern eingehen. Die Flügel greifen in eine mittige Aussparung des Schalenkerns ein. Gleichzeitig liegt der Schalenkern an stirnseitig angeordneten Stützflächen der Leiterplatte an. Durch die Flügel wird der Schalenkern zentriert und durch die Stützfläche eine exakt senkrechte Lage des Schalenkerns zur Leiterplatte sichergestellt. Der Schalenkern ist in dieser Ausführung gleichzeitig als Spulengehäuse ausgebildet. Es kann aber auch ein separates Spulengehäuse vorgesehen sein. Der Schalenkern kann so auf besonders einfache Weise angebracht werden. Der Schalenkern der Spule ist somit form-und/oder kraftschlüssig mit der Leiterplatte verbunden. Vorzugsweise sind die Flügel Teil der Leiterplatte, sind also keine an der Platte befestigten Federn, sondern bestehen aus demselben Material wie die Leiterplatte selbst. So kann auf sehr einfache Weise eine Klemmverbindung bereit gestellt werden, welche zudem sehr maßhaltig ist. In dieser erfindungsgemässen Ausführung lässt sich auf sehr einfache Weise ein induktiver Sensor mit hoher Genauigkeit montieren.

Zur Durchführung der Kontakte weist der Schalenkern asymmetrisch zu einer Rotationsachse verlaufende Durchführungen auf. Unter der Rotationsachse wird eine Achse verstanden, welche rotationssymmetrisch zur Mantelfläche des Schalenkerns ausgebildet ist.

Bei einer bevorzugten Ausführungsform der Erfindung ist, im Gegensatz zu handelsüblichen Schalenkemen, die Mantelfläche des Schalenkerns geschlossen und die Kontakte sind durch den Boden des Schalenkerns geführt. Durch die fehlenden seitlichen Öffnungen werden Verluste reduziert und es wird in dieser vorteilhaften Ausführung eine bessere Performance des Sensors erreicht.

Bei einer bevorzugten Ausführungsform der Erfindung erfolgt die Befestigung der Leiterplatte in dem Gehäuse form- und/oder kraftschlüssig.

Somit muss zur Befestigung der Leiterplatte ebenfalls kein Klebstoff verwendet werden, was die Montage des Sensors erleichtert. In Verbindung mit einer form-und/oder kraftschlüssigen Verbindung der Leiterplatte mit einem Spulengehäuse kann so der gesamte Sensor auf sehr einfache Weise ohne Klebstoff und sogar ohne die Verwendung eines Werkzeugs zusammen gefügt werden. Dabei kann die Leiterplatte zunächst mit einem Spulengehäuse, insbesondere einem Spulenkörper, form- und/oder kraftschlüssig verbunden werden. Vorzugsweise wird ein Spulenkörper mit dem Spulengehäuse ebenfalls form- und/oder kraftschlüssig verbunden. Die Bauteile sind so exakt zueinander ausgerichtet und die Kontakte der Spule können sodann mit der Leiterplatte verlötet werden. Demgemäß ist in Weiterbildung der Erfindung vorgesehen, dass die Spule und der Schalenkern an der Leiterplatte mittels zweier Lötstellen mechanisch gehalten und befestigt wird, wobei gleichzeitig die Spule mittels der beiden Lötstellen elektrisch kontaktiert wird.

Es versteht sich, dass dennoch im Sinne der Erfindung auch vorgesehen sein kann, das Sensorgehäuse mit einer Vergussmasse auszugießen. Diese Vergussmasse dient in erster Linie dem besseren Feuchtigkeitsschutz.

Bei einer Weiterbildung der Erfindung weist die Leiterplatte seitliche Kontaktlaschen auf. Über diese Kontaktlaschen, welche an der inneren Wand des Gehäuses anliegen, kann das innere Gehäuse mit einer Schutzbeschaltung auf der Leiterplatte elektrisch verbunden sein. Hierzu besteht das Gehäuse aus Metall oder ist mit einer metallischen Schicht oder mit einem metallischen Einsatz versehen. Durch diese Ausgestaltung wird ein Sensor mit geringerer Empfindlichkeit gegenüber elektromagnetischen Strahlungen bereitgestellt.

Bei einer Weiterbildung der Erfindung sind die Kontaktlaschen als Passung und/oder Führung für die Leiterplatte im Gehäuse ausgebildet. Die Kontaktlaschen übernehmen somit neben der Kontaktierung zur Gehäuseabschirmung die Aufgabe, die Leiterplatte in dem Gehäuse exakt zu positionieren.

Bei einer bevorzugten Ausführungsform sind sowohl die Kontakte der Spule, als auch die Kontakte zum Anschluss des Sensors auf einer selben Oberfläche der Leiterplatte lötbar. Damit kann auf ein ansonsten aufwändiges Lötverfahren verzichtet werden. Ferner ist eine manuelle Lötung nicht mehr zwingend erforderlich.

Vielmehr kann die Verbindung der Leiterplatte mit Anschlusskontakten sowie mit der Spule automatisiert in einem einzigen Arbeitsschritt durchgeführt werden. Aber auch eine manuelle Lötverbindung ist wesentlich vereinfacht.

Der Sensor bzw. das Sensorgehäuse ist vorzugsweise im wesentlichen kreiszylindrisch ausgebildet, wobei es sich versteht, dass typischerweise ein derartiger Sensor noch Griffflächen, ein Gewinde zum Anbringen eines Steckers etc. umfasst, ohne dass hierdurch von der kreisrylindrischen Ausgestaltung im Sinne der Erfindung abgewichen wird.

Bei einer bevorzugten Ausführungsform der Erfindung umfasst die Spule um einen Spulenkörper gewickelte Windungen, wobei der Spulenkörper eingespritzte Kontaktstifte umfasst und eine Temperaturbeständigkeit von mindestens 130° C aufweist. So kann der Spulenkörper mit der Leiterplatte verlötet werden, ohne dass die Gefahr besteht, dass während des Lötens der Spulenkörper beschädigt wird.

Geeignet ist unter anderem ein hochtemperaturfestes Fiussigkristallpolymer (Liquid Crystal Polymer, LCP).

Die relativ dünnen Windungen der Spule können dabei um die Kontaktstifte der Spule gewickelt und anschließend verlötet werden.

Die Windungen der Spule verlaufen im wesentlichen senkrecht zur Leiterplatte, dass heißt eine Ebene, die entlang einer Windung der Spule liegt, ist senkrecht zur Leiterplatte angeordnet.

Die Leiterplatte liegt ihrerseits im Wesentlichen entlang einer Rotationsachse des Gehäuses, wobei unter einer Rotationsachse eine Symmetrieachse der Mantelfläche des vorzugsweise kreiszylindrisch ausgebildeten Gehäuses verstanden wird.

Die Erfindung betrifft des Weiteren ein Verfahren zur Montage eines vorstehend beschriebenen Sensors, insbesondere eines induktiven Sensors. Dabei wird eine Spule mit asymmetrisch ausgebildeten Kontakten sowie Kontaktstiften zur Kontaktierung des Sensors auf eine Oberfläche einer Leiterplatte gelötet. Die Spule wird in einen Schalenkern eingesetzt, wobei der Schalenkern mit der Leiterplatte form- und/oder kraftschlüssig verbunden wird.

Durch die Erfindung kann auf Klebeverbindungen verzichtet werden, was die Montage des Sensors erheblich vereinfacht.

Die Leiterplatte wird vorzugsweise entlang einer Rotationsachse des Gehäuses eingeschoben und kann so die maximal mögliche Breite im Gehäuse einnehmen. Gleichzeitig kann die Leiterplatte so in einem kreiszylindrisch ausgebildeten Innengehäuse ohne zusätzliche Führungen formschlüssig gehalten werden. Bei einer Weiterbildung der Erfindung wird die Leiterplatte durch seitliche Kontaktlaschen geführt und so passgenau in dem Gehäuse angeordnet.

Die Spule umfasst bei einer bevorzugten Ausführungsform der Erfindung einen Spulenkörper aus Kunststoff, insbesondere einen Spulenkörper aus einem Flüssigkristallpolymer. Dieser Spulenkörper wird auf einen Schalen kern geklemmt, was ebenfalls die Montage erleichtert.

Bei einer weiteren Ausführungsform der Erfindung ist die Leiterplatte sensorseitig mit eben ausgebildeten Stützflächen versehen, welche der rechtwinkligen Anlage eines Spulengehäuses, insbesondere des zuvor beschriebenen Schalenkerns, dienen. Hierzu wird vorzugsweise die Leiterplatte an ihrer Stirnseite maßhaltig mit gefrästen Flächen versehen. Hierdurch kann das Spulengehäuse exakt zur Leiterplatte positioniert werden, wodurch gewährleistet ist, dass die Spulenachse sehr exakt mit der beabsichtigten Wirkrichtung des Sensors übereinstimmt.

Die vorliegende Erfindung wird mit Bezug auf die beigefügten Zeichnungen detaillierter erläutert, wobei gleiche Bezugszeichen gleiche Strukturen bezeichnen.

In der Zeichnung gilt:
- Fig. 1: zeigt eine perspektivische Ansicht eines Sensors mit aufgeschnittenem Gehäuse,
- Fig. 2: zeigt eine Schnittansicht des Sensors, wobei die Schnittebene senkrecht zur Leiterplatte und entlang einer Rotationsachse des Gehäuses verläuft,
- Fig. 3: zeigt die in dem Gehäuse eines Sensors angeordneten Bauelemente,
- Fig. 4: zeigt eine Detailansicht eines Spulenkörpers,
- Fig. 5: zeigt eine perspektivische Ansicht eines Schalenkerns, welcher der Aufnahme des Spulenkörpers dient,
- Fig. 6: zeigt eine weitere perspektivische Ansicht des Schalenkerns aus einer anderen Perspektive
- Fig. 6a: zeigt eine Schnittansicht des in Fig. 5 und 6 gezeigten Schalen kerns,
- Fig. 7: zeigt eine Draufsicht auf die Leiterplatte,
- Fig. 8: zeigt eine Schnittansicht des Sensors in Draufsicht auf die Leiterplatte,
- Fig. 9: zeigt eine Schnittansicht des Sensors, senkrecht zur Leiterplatte,
- Fig. 10: zeigt eine Detailansicht des an der Leiterplatte befestigten Spulengehäuses und
- Fig. 11: zeigt eine weitere Detailansicht des an der Leiterplatte befestigten Spulengehäuses.

### Detaillierte Beschreibung der Zeichnungen

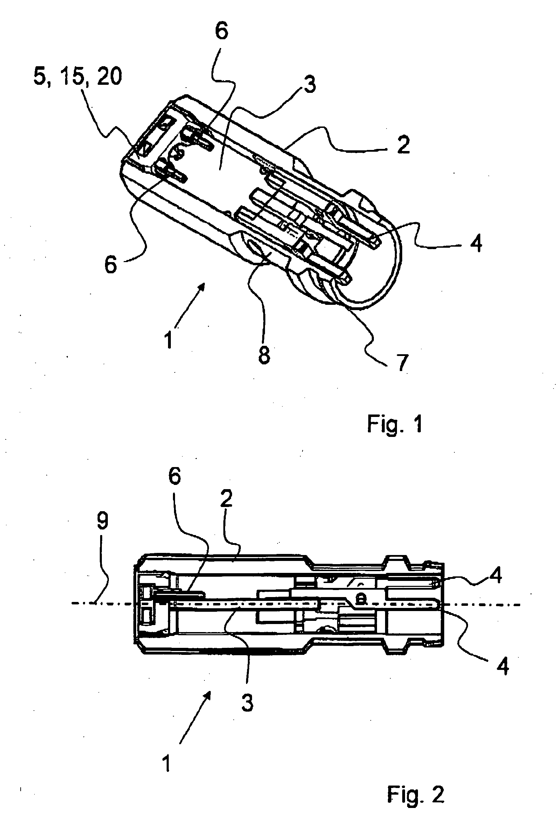

Bezug nehmend auf Fig. 1 sollen die wesentlichen Elemente eines induktiven Sensors 1 dargestellt werden. Zu sehen ist eine perspektivische Ansicht, bei welcher der obere Teil des Gehäuses 2 entfernt ist. Der Sensor 1 umfasst ein Gehäuse 2, in welchem eine Leiterplatte 3 angeordnet ist. Das Gehäuse 2 hat eine im Wesentlichen kreiszylindrische Form. An der Vorderseite des Gehäuses befindet sich eine Spule 5.

Auf einer der Spule 5 gegenüberliegenden Seite des Sensors 1 ist ein Sensoranschluss 4 angeordnet. Sowohl der Sensoranschluss 4 als auch Kontakte 6 der Spule 1, sind elektrisch mit der Leiterplatte 3 verbunden. Die Leiterplatte 3 weist weitere elektronische Komponenten wie integrierte Schaltkreise auf, welche der Auswertung und Verstärkung der Sensorsignale dienen (nicht dargestellt).

Weiter weist das Gehäuse 2 eine Grifffläche 8 sowie einen Kragen 7 auf. Der Kragen 7 kann auch als Gewinde ausgebildet sein und dem Anschluss eines Steckers (nicht dargestellt) dient. Bereits in dieser Ansicht ist zu erkennen, dass sowohl der Sensoranschluss 4 als auch die Kontakte 6 der Spule 5 alle auf einer Seite der Leiterplatte 3 angeordnet sind. Damit wir ein Montageprozess des Sensors 1 wesentlich erleichtert.

Wie genau diese Ausgestaltung möglich ist, wird unter Bezugnahme auf weitere Zeichnungen erläutert.

Fig. 2 zeigt eine Schnittansicht einer Rotationsachse 9 des Spulengehäuses und entlang einer senkrecht zur Leiterplatte 3 verlaufenden Ebene. In dieser Ansicht ist zu erkennen, dass die Kontakte 6 der Spule 5 und der Sensoranschluss 4, zumindest insoweit diese an die Leiterplatte 3 angrenzen, oberhalb der Leiterplatte 3 liegen.

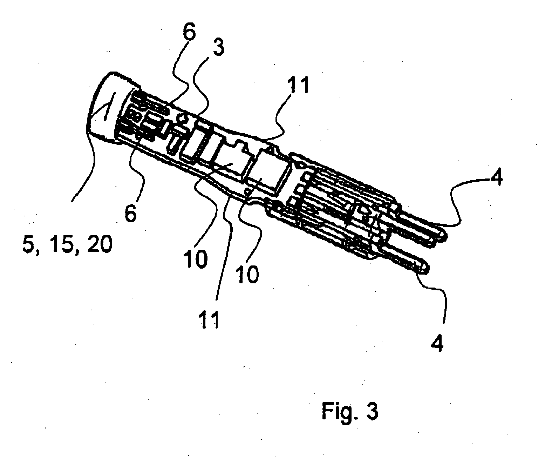

Bezug nehmend auf Fig. 3 soll der Aufbau des Sensors 1 näher erläutert werden. Der Sensors 1 besteht wenigstens aus einem Schalenkern 20, einer Spule 5 und einem Spulenkörper 15. Die Kontakte 6 der Spule 5 sind elektrisch mit der Leiterplatte 3 verbunden. Die elektrische Verbindung erfolgt vorzugsweise durch Löten. Mit dieser Lötung werden die Spule 5 und der Schalenkern 20 an der Leiterplatte 3 mittels zweier Lötstellen mechanisch gehalten und befestigt, wobei gleichzeitig die Spule 5 mittels der beiden Lötstellen elektrisch kontaktiert wird.

Die Leiterplatte 3 hat eine im Wesentlichen rechteckige, langgezogene Form und weist integrierte Schaltkreise 10 auf, die beispielsweise der Verstärkung und Auswertung der Sensorsignale dienen.

Die zusätzliche mechanische Verbindung zwischen der Spule 5 und Leiterplatte 3 soll im Folgenden Bezug nehmend auf weitere Zeichnungen erläutert werden.

Weiter weist die Leiterplatte 3 seitliche Kontaktlaschen 11 auf, in denen sich die Breite der Leiterplatte 3 vergrößert.

Diese Kontaktlaschen 11 dienen einer elektrischen Verbindung mit der Innenwand des Sensorgehäuses 3 und dienen gleichzeitig als Passung oder Führung der Leiterplatte 3 in dem Sensorgehäuse 3. Die Kontaktlaschen 11 können über einen Kondensator (nicht dargestellt) elektrisch mit dem Gehäuse 2 des Sensors 1 verbunden sein. Rückseitig ist an der Leiterplatte 3 der Sensoranschluss 4 angelötet.

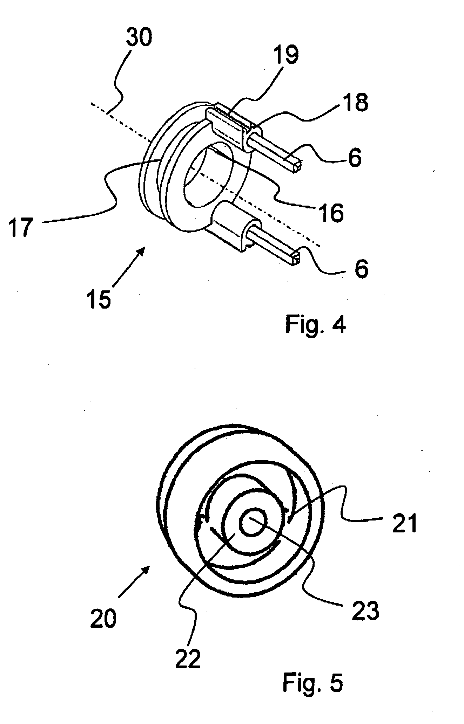

Bezug nehmend auf die Figuren Fig. 4 bis Fig. 6 sollen die Details der Ausgestaltung der Spule 5 näher erläutert werden. Fig. 4 zeigt den Spulenkörper 15, weicher eine Nut 17 umfasst, auf die die einzelnen dünnen Windungen der Spule 5 (nicht dargestellt) gewickelt werden. Weiter weist der Spulenkörper 15 die Kontakte 6 zum Anschluss der Spule auf. Diese Kontakte verlaufen im Wesentlichen in Richtung der Spulenachse 30.

Zwischen den Kontakten 6 und der Nut 17, in welchen die Windungen der Spule 5 (nicht dargestellt) verlaufen, sind Führungsnuten 19 vorgesehen, in welche die beiden Enden des Spulendrahtes (nicht dargestellt) eingelegt oder eingeklemmt werden können. Der Spulendraht kann um die Kontakte 6 gewickelt und dort verlötet werden.

Der Spulenkörper 15 besteht mit Ausnahme der Kontakte 6 aus einem hochtemperaturfesten Kunststoff, insbesondere aus einem Flüssigkristallpolymer, welcher im Spritzgussverfahren mit den Kontakten 6 verbunden werden kann. Vorzugsweise werden als Kontakte 6 gerädelte Kontaktstifte verwendet, aus welchen sich der Draht der Spule 5 (nicht dargestellt) leichter aufwickeln und fest löten lässt.

Der Spulenkörper 15 ist ringförmig ausgebildet und weist an seiner inneren Mantelfläche Klemmstege 16 auf, die seiner Befestigung dienen.

In diesem Ausführungsbeispiel sind drei im Winkel von jeweils 120° zueinander versetzte Klemmstege 16 vorgesehen.

Fig. 5 zeigt einen Schalenkern 20, welcher der Aufnahme des in Fig. 4 dargestellten Spulenkörpers 15 dient und somit das eigentliche Gehäuse der Spule 5 bildet. Der Schalenkern 20, welcher aus Ferrit gefertigt sein kann, ist im Wesentlichen kreiszylinderförmig ausgestaltet und umfasst eine Ausnehmung 21, die der Aufnahme des Spulenkörpers 15 (siehe Fig. 4) dient.

Zur Befestigung des Spulenkörpers 15 ist ein im Verhältnis zur Ausnehmung 21 axial angeordneter Zylinder 22 vorgesehen, welcher auch leicht konisch angeschrägt sein kann. Auf diesen Zylinder 22 wird der Spulenkörper 15 geklemmt. Auf eine Verwendung eines Klebstoffs kann damit verzichtet werden.

Der Zylinder 22 weist eine mittige Bohrung 23 auf, deren Funktion in den folgenden Zeichnungen näher erläutert wird.

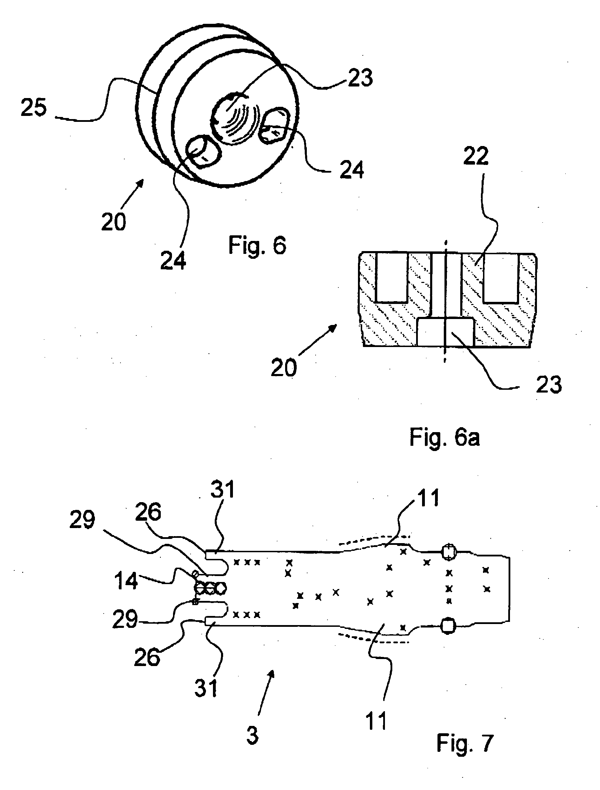

Fig. 6 zeigt eine weitere perspektivische Ansicht des Schalenkerns 20. Zu erkennen ist die mittige Bohrung 23. Der Begriff "Bohrung" dient im Sinne der Erfindung nur der geometrischen Definition. Es ist hier eine im Wesentlichen kreiszylinderförmige Aussparung definiert.

Weiter weist der Schalen kern 20 zwei asymmetrisch angeordnete Durchführungen 24 auf, welche in diesem Ausführungsbeispiel einen Winkel zwischen vorzugsweise 80 bis 150°, besonders bevorzugt 110 bis 120°, einschließen.

Die Mantelfläche 25 des Schalenkerns 20 kann, wie in diesem Ausführungsbeispiel dargestellt, ebenfalls zumindest abschnittsweise leicht angeschrägt sein.

Fig. 6a zeigt eine Schnittansicht des Schalenkerns 20 entlang einer auf seiner Mittelachse liegenden Ebene. Die Bohrung 23 weist zwei unterschiedliche Durchmesser auf, wobei der größere Durchmesser zur Klemmung der Leiterplatte 3 dient, wie im Folgenden noch näher dargestellt wird. Der gegenüberliegende Zylinder 22 dient der Klemmung des Spulenkörpers 15 (siehe Fig. 4). Es versteht sich, dass sowohl die Innenfläche der Bohrung 23 als auch die Außenfläche des Zylinders 22 noch Stege oder ähnliches aufweisen können, um die Klemmwirkung durch eine gleichzeitig formschlüssige Verbindung zu verbessern.

Fig. 7 zeigt eine schematische Draufsicht auf die Leiterplatte 3. Die Leiterplatte 3 ist im Wesentlichen rechteckig ausgebildet, weist aber seitliche Kontaktlaschen 11 auf, welche aus dieser rechtwinkligen Form herausragen.

Die Kontaktlaschen 11 dienen, wie bereits dargestellt, der Kontaktierung der Innenwand des Gehäuses 2 sowie als Pass- beziehungsweise Führungsmittel.

Sensorseitig ist die Leiterplatte 3 mit in dieser Darstellung senkrecht zur Papierebene verlaufenden Stützflächen 26 versehen. Diese Stützflächen 26 werden senkrecht und maßgenau an den Rändern der Leiterplatte 3 ausgebildet. Hierzu weist die Leiterplatte 3 hervorstehende Stege 31 auf.

Zwischen den Stegen 31 befindet sich ein weiterer Steg, welcher mit einer Ausnehmung 14 versehen ist. Hierdurch wird der weitere Steg in zwei Flügel 29 unterteilt, welche als Federelemente wirksam sind und mit denen der Schalenkern 20 mit seiner mittigen Bohrung 23 (siehe Fig. 6a) auf die Leiterplatte 3 geklemmt werden kann. Zur Bereitstellung einer zusätzlich formschlüssigen Verbindung können die Flügel 29 randseitige Rastmittel (nicht dargestellt) aufweisen. Die Stirnfläche der Flügel 29 ragt über die Stützflächen 26 hinaus, um das zylindrisch, als Schalenkern 20 ausgebildete Spulengehäuse mit einer zentralen Aussparung auf die Leiterplatte 3 zu klemmen, wobei der Schalenkern 20 an die Stützflächen 26 zur Anlage kommt.

Die Ausnehmung 14 wird in diesem Ausführungsbeispiel durch drei sich teilweise überschneidende Bohrungen gebildet. Auch andere Einschnitte, wie beispielsweise ein gerader Einschnitt sind denkbar.

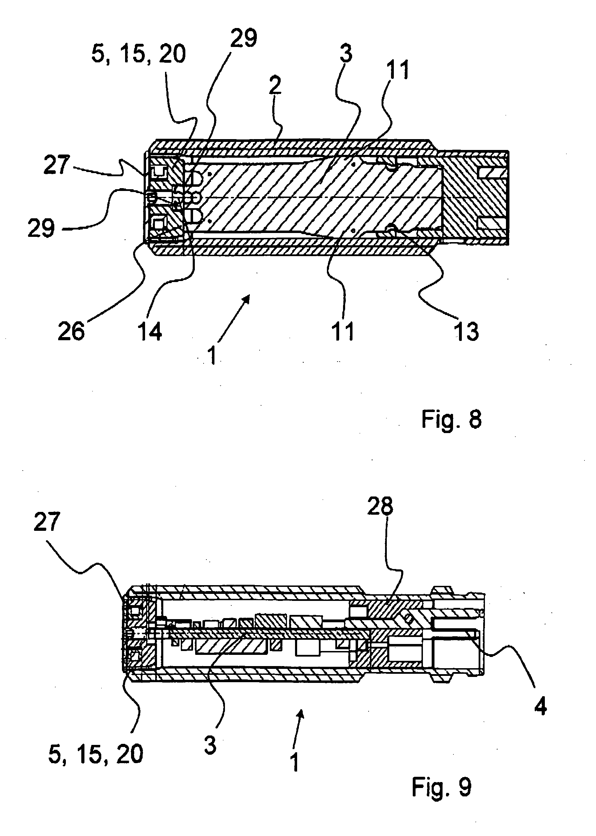

Fig. 8 zeigt eine Schnittansicht des Sensors 1, wobei der Schnitt hier parallel zur Oberfläche entlang der Leiterplatte 3 erfolgt. Die Leiterplatte 3 umfasst seitlich angeordnete Aussparungen 13. Bei der Montage wird die Leiterplatte 3 in das Gehäuse 2 geschoben. Zur exakten Positionierung weist die Leiterplatte 3 seitliche Kontaktlaschen 11 auf, mit denen zugleich die Innenwand des Gehäuses 2 kontaktiert wird. Dieses besteht aus Metall oder weist innenseitig eine metallische Beschichtung oder einen metallischen Einsatz auf.

Die Spule 5 ist an der Leiterplatte 3 befestigt, in dem die Flügel 29, wie im Folgenden noch detailliert dargestellt wird, in die Bohrung des Schalenkerns 20 geklemmt sind.

Damit der Schalenkern exakt senkrecht zur Leiterplatte 3 positioniert ist, liegt er rückseitig an den Stützflächen 26 an.

Vorne ist der Sensor 1 mit einer vorderen Abschlussplatte 27 verschlossen, welche durch eine Presspassung befestigt werden kann oder welche nach Füllung des Gehäuses 2 mit einer Vergussmasse eingesetzt werden kann.

Fig. 9 zeigt eine weitere Schnittansicht des Sensors 1 hier senkrecht zur Leiterplatte 3. Die Leiterplatte 3 sowie die Spule 5 sind zwischen vorderer Abschlussplatte 27 und hinterer Abschlussplatte 28 angeordnet. Durch die Anschlussplatten 27 und 28 sowie durch eine Vergussmasse wird der Sensor 1 hermetisch verkapselt. Es versteht sich, dass hierzu noch weitere Dichtelemente vorhanden sein können. Der Sensoranschluss 4, der mit der Leiterplatte 3 verbunden ist, ist durch eine hintere Abschlussplatte 28 geführt.

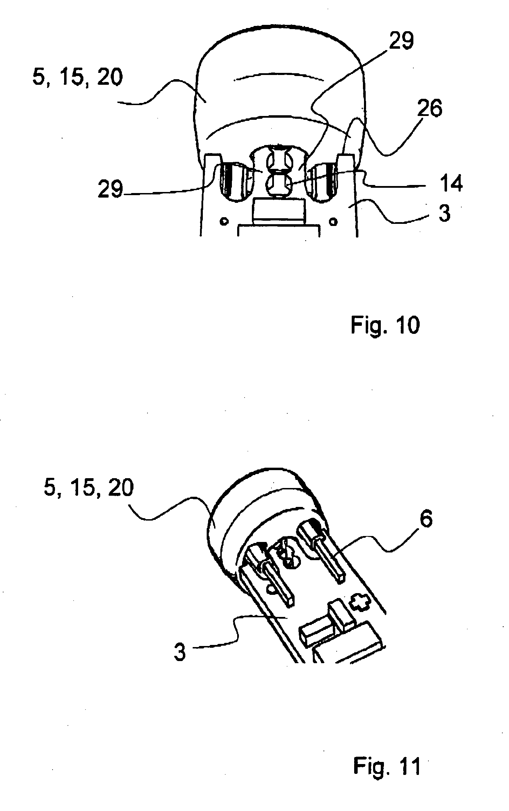

Fig. 10 zeigt eine perspektivische Detailansicht des vorderen Teils eines Sensors 1. Zu erkennen ist die Spulen 5 mit dem Schalenkern 20. Der Schalenkern 20 ist in diesem Ausführungsbeispiel mechanisch mittels der Flügel 29, die in die Aussparung des als Schalenkern 20 eingreifen, verbunden. Die Flügel 29 sind vorzugsweise als Teil der Leiterplatte 3 ausgebildet.

Der Schalenkern 20 liegt rückseitig an den Stützflächen 26 an. Durch die gleichzeitige Zentrierung des Schalenkerns 20 aufgrund der Klemmung auf die Flügel 29 ist dieses auf sehr einfache Weise maßgenau zur Leiterplatte 3 positioniert.

Fig. 11 zeigt eine weitere Detailansicht des vorderen Teiles des Sensors 1. Zu erkennen sind hier insbesondere die Kontakte 6, welche mit der Leiterplatte 3 elektrisch und mechanisch durch Löten verbunden sind.

Durch die Erfindung kann ein induktiver Sensor 1 bereitgestellt werden, welcher sich leichter montieren lässt, wobei trotz der vereinfachten Montage eine verbesserte Qualität sichergestellt wird.

### Bezugszeichenliste:

- 1.: Sensor
- 2.: Gehäuse
- 3.: Leiterplatte
- 4.: Sensoranschluss
- 5.: Spule
- 6.: Kontakte
- 7.: Kragen
- 8.: Gnffflächen
- 9.: Rotationsachse
- 10.: integrierter Schaltkreis
- 11.: Kontaktlasche
- 13.: Aussparung
- 14.: Ausnehmung an Leiterplatte 3
- 15.: Spulenkörper
- 16.: Klemmsteg
- 17.: Nut
- 19.: Führungsnut
- 20.: Schalenkern
- 21.: Ausnehmung an Schalenkern 20
- 22.: Zylinder
- 23.: Bohrung
- 24.: Durchführung
- 25.: Mantelfläche
- 26.: Stützfläche
- 27.: vordere Abschlussplatte
- 28.: hintere Abschlussplatte
- 29.: Flügel
- 30.: Spulenachse
- 31.: Steg

## Patentansprüche

1. Induktiver Sensor umfassend eine in einem im Wesentlichen zylindrischen Gehäuse (2) angeordnete Spule (5), welche mit einer ebenfalls in dem Gehäuse (2) angeordneten Leiterplatte (3) elektrisch verbunden ist, wobei an der Leiterplatte (3) auf einer der Spule (5) gegenüberliegenden Seite des Gehäuses (2) ein Sensoranschluss (4) vorgesehen ist, wobei Windungen der Spule (5) in einer Nut (17) auf einen Spulenkörper (15) gewickelt sind und die Spule (5) zwei Kontakte (6) aufweist, welche mit der Leiterplatte (3) verbunden sind,
**dadurch gekennzeichnet, dass**
an dem Spulenkörper die zwei Kontakte (6) ausgebildet sind, welche parallel zur Spulenachse (30) verlaufen und deren Mittelpunkte in einer Ebene senkrecht zur Spulenachse zu der Spulenachse (30) hin einen Winkel zwischen 60° und 170° einschliessen, wobei die Spulenachse (30) in der Mitte der Spule (5) senkrecht durch eine Ebene verläuft, welche von den Windungen der Spule (5) gebildet wird.

2. Induktiver Sensor nach Anspruch 1, **dadurch gekennzeichnet, dass** die Mittelpunkte der Kontakte (6) zu der Spulenachse (30) hin einen Winkel zwischen 110° und 120° einschliessen.

3. Induktiver Sensor nach einem der vorstehenden Ansprüche, **dadurch gekennzeichnet, dass** die Leiterplatte (3) im Wesentlichen mittig in dem zylindrischen Gehäuse (2) angeordnet ist.

4. Induktiver Sensor nach einem der vorstehenden Ansprüche, **dadurch gekennzeichnet, dass** der Spulenkörper (15) ringförmig ausgebildet ist und innere Klemmstege (16) aufweist.

5. Induktiver Sensor nach einem der vorstehenden Ansprüche, **dadurch gekennzeichnet, dass** der Spulenkörper (15) in einem Schalenkern (20) angeordnet ist, wobei der Schalenkern (20) Kanäle zur Durchführung (24) der zwei Kontakte (6) aufweist.

6. Induktiver Sensor nach dem vorstehenden Anspruch, **dadurch gekennzeichnet, dass** der Schalenkern (20) an einem Ende des Gehäuses (2) angeordnet ist, kraft- und/oder formschlüssig befestigt ist und die Mantelfläche (25) des Schalenkerns (20) vorzugsweise geschlossen ist.

7. Induktiver Sensor nach einem der vorstehenden Ansprüche, **dadurch gekennzeichnet, dass** die Spule (5) und der Schalenkern (20) an der Leiterplatte (3) mittels zweier Lötstellen mechanisch gehalten und befestigbar sind, wobei gleichzeitig die Spule (5) mittels der beiden Lötstellen elektrisch kontaktierbar ist.

8. Induktiver Sensor nach einem der vorstehenden Ansprüche, **dadurch gekennzeichnet, dass** die Leiterplatte (3) als Feder wirkende Flügel (29) aufweist, auf denen der Schalenkern (20) befestigbar ist.

9. Induktiver Sensor nach dem vorstehenden Anspruch, **dadurch gekennzeichnet, dass** der Schalenkern (20) eine kreiszylinderförmige Aussparung (23) aufweist, in den die als Feder wirkende Flügel (29) mechanisch in Eingriff bringbar sind.

10. Induktiver Sensor nach einem der vorstehenden Ansprüche, **dadurch gekennzeichnet, dass** die Leiterplatte stirnseitige Stützflächen (26) aufweist, an denen der Schalenkern (20) zur Anlage bringbar ist.

11. Induktiver Sensor nach einem der vorstehenden Ansprüche, **dadurch gekennzeichnet, dass** die Leiterplatte (3) mit dem Gehäuse (2) des Sensors form- und/oder kraftschlüssig verbunden ist, wobei die Leiterplatte (3) vorzugsweise seitliche Kontaktlaschen (11) aufweist und wobei die Kontaktlaschen (11) vorzugsweise als Passung und/oder Führung für die Leiterplatte (3) im Gehäuse (2) ausgebildet sind.

12. Induktiver Sensor nach einem der vorstehenden Ansprüche, **dadurch gekennzeichnet, dass** die Kontakte (6) der Spule (5) und der Sensoranschluss (4) auf einer selben Oberfläche der Leiterplatte (3) lötbar sind.

13. Induktiver Sensor nach einem der vorstehenden Ansprüche, **dadurch gekennzeichnet, dass** der Spulenkörper (15) eingespritzte Kontaktstifte (6) umfasst.

## Claims

1. Inductive sensor comprising a coil structure (5) arranged in an essentially cylindrical housing (2) and electrically connected to a printed circuit board (3) likewise arranged in the housing (2), whereby a sensor terminal (4) is provided at the printed circuit board (3) on a side of the housing (2) opposite to the coil structure (5), whereby turns of the coil structure (5) are wound in a groove (17) about a coil body (15) and the coil structure (5) has two contacts (6) which are connected to the printed circuit board (3),
**characterized in that**
at the coil body the two contacts (6) are designed which run parallel to the coil axis (30) and have their center points in a plane perpendicular to the coil axis enclosing an angle between 60° and 170° towards the coil axis (30), whereby the coil axis (30) in the center of the coil structure (5) is perpendicular to the plane formed by the turns of the coil (5).

2. Inductive sensor in accordance with Claim 1, **characterized in that** the center points of the contacts (6) enclose towards the coil axis (30) an angle between 110° and 120°.

3. Inductive sensor in accordance with one of the above Claims, **characterized in that** the printed circuit board (3) is essentially arranged centrally in the cylindrical housing (2).

4. Inductive sensor in accordance with one of the above Claims, **characterized in that** the coil body (15) has a ring-shaped design and has internal clamping webs (16).

5. Inductive sensor in accordance with one of the above Claims, **characterized in that** the coil body (15) is arranged in a shell core (20), whereby the shell core (20) has ducts (24) for leading through the two contacts (6).

6. Inductive sensor in accordance with one of the above Claims, **characterized in that** the shell core (20) is arranged at an end of the housing (2), is fastened in an interlocking and/or force-fitting manner and the jacket surface of the shell core (20) preferably is closed.

7. Inductive sensor in accordance with one of the above Claims, **characterized in that** the coil structure (5) and the shell core (20) are held mechanically at, and can be fastened to the printed circuit board (3) by means of two soldered joints, whereby the coil (5) can be contacted electrically by the two soldered joints at the same time.

8. Inductive sensor in accordance with one of the above Claims, **characterized in that** the printed circuit board (3) has wings forming springs (29) to which the shell core (20) can be fastened.

9. Inductive sensor in accordance with the above Claim, **characterized in that** the shell core has a circular cylindrical recess (23) wherein the wings forming springs (29) are mechanically engageable.

10. Inductive sensor in accordance with one of the above Claims, **characterized in that** the printed circuit board has front-side support surfaces (26) whereto the shell core (20) can be brought to bear.

11. Inductive sensor in accordance with one of the above Claims, **characterized in that** the printed circuit board (3) is fastened to the housing (2) in an interlocking and/or force-fitting manner, whereby the printed circuit board (3) has preferably lateral contact elements (11) and whereby the contact elements (11) are designed preferably to fit and/or guide the printed circuit board (3) in the housing (2).

12. Inductive sensor in accordance with one of the above Claims, **characterized in that** the contacts (6) of the coil structure (5) and the sensor terminal (4) can be soldered to the same surface of the printed circuit board (3).

13. Inductive sensor in accordance with one of the above Claims, **characterized in that** the coil body (15) comprises injection-molded contact pins (6).

## Revendications

1. Détecteur inductif comprenant une bobine (5) disposée dans un boîtier essentiellement cylindrique (2), qui est raccordée de manière électrique à une carte de circuit imprimé (3) disposée également dans le boîtier (2), un raccord de détecteur (4) étant prévu au niveau de la carte de circuit imprimé (3) sur un côté du boîtier (2) opposé à la bobine (5), les spires de la bobine (5) étant enroulées dans une rainure (17) sur un corps de bobine (15) et la bobine (5) présentant deux contacts (6) raccordés à la carte de circuit imprimé (3),
**caractérisé en ce que**
les deux contacts (6) sont formés sur le corps de bobine, s'étendent parallèlement à l'axe de bobine (30) et leurs points centraux dans un plan perpendiculaire à l'axe de bobine vers l'axe de bobine (30) comprennent un angle entre 60° et 170°, l'axe de bobine (30) s'étendant au centre de la bobine (5) de manière perpendiculaire à travers un plan, qui est formé par les spires de la bobine (5).

2. Détecteur inductif selon la revendication 1, **caractérisé en ce que** les points centraux des contacts (6) jusqu'à l'axe de bobine (30) comprennent un angle entre 110 et 120°.

3. Détecteur inductif selon l'une des revendications précédentes, **caractérisé en ce que** la carte de circuit imprimé (3) est disposée essentiellement au centre dans le boîtier cylindrique (2).

4. Détecteur inductif selon l'une des revendications précédentes, **caractérisé en ce que** le corps de bobine (15) est de forme annulaire et présente des brides de serrage internes (16).

5. Détecteur inductif selon l'une des revendications précédentes, **caractérisé en ce que** le corps de bobine (15) est disposé dans un noyau enveloppé (20), le noyau enveloppé (20) présentant des canaux destinés à la traversée (24) des deux contacts (6).

6. Détecteur inductif selon la revendication précédente, **caractérisé en ce que** le noyau enveloppé (20) est disposé à une extrémité du boîtier (2), est fixé à force et/ou par conjugaison de forme et la surface d'enveloppe du noyau enveloppé (20) est de préférence fermée.

7. Détecteur inductif selon l'une des revendications précédentes, **caractérisé en ce que** la bobine (5) et le noyau enveloppé (20) sont maintenus mécaniquement et peuvent être fixés au niveau de la carte de circuit imprimé (3) au moyen de deux joints brasés, dans le même temps la bobine (5) pouvant être soumise au contact électrique au moyen des deux joints gravés.

8. Détecteur inductif selon l'une des revendications précédentes, **caractérisé en ce que** la carte de circuit imprimé (3) présente des ailettes (29) servant de languettes, sur lesquelles le noyau enveloppé (20) peut être fixé.

9. Détecteur inductif selon la revendication précédente, **caractérisé en ce que** le noyau enveloppé présente un évidement de forme cylindrique circulaire (23), dans lequel les ailettes (29) servant de languettes peuvent être mises en prise mécaniquement.

10. Détecteur inductif selon l'une des revendications précédentes, **caractérisé en ce que** la carte de circuit imprimé présente des surfaces d'appui frontales (26) sur lesquelles le noyau enveloppé (20) peut pendre appui.

11. Détecteur inductif selon l'une des revendications précédentes, **caractérisé en ce que** la carte de circuit imprimé (3) est raccordée à force et/ou par conjugaison de forme au boîtier (2) du détecteur, la carte de circuit imprimé (3) présentant de préférence des attaches de contact latérales (11) et les attaches de contact (11) étant conçues de préférence en tant qu'ajustement et/ou guidage pour la carte de circuit imprimé (3) dans le boîtier (2).

12. Détecteur inductif selon l'une des revendications précédentes, **caractérisé en ce que** les contacts (6) de la bobine (5) et le raccord de détecteur (4) peuvent être brasés sur une même surface de la carte de circuit imprimé (3).

13. Détecteur inductif selon l'une des revendications précédentes, **caractérisé en ce que** le corps de bobine (15) comprend des broches injectées (6).
